# DEMANDE DE BREVET EUROPEEN

(11) **EP 4 451 272 A1**
(43) Date de publication de la demande: **23.10.2024**
(21) Numéro de dépôt: 24169626.9
(22) Date de dépôt: 11.04.2024
(51) Int. Cl.: G11C 16/22, G11C 16/04, G11C 7/24

(54) **PROCÉDÉ D'ALTÉRATION DE DONNÉES STOCKÉES DANS UNE MÉMOIRE, ET CIRCUIT INTÉGRÉ CORRESPONDANT**

(30) Priorité: 20.04.2023 FR 2303965
(71) Demandeur: STMicroelectronics International N.V., 1228 Plan-les-Ouates, Geneva (CH)
(72) Inventeur: La désignation de l'inventeur n'a pas encore été déposée
(74) Mandataire: Casalonga

(57) **Abrégé**

Selon un aspect, il est proposé un circuit intégré (IC) comprenant : au moins une cellule-mémoire (MEM), ladite cellule-mémoire (MEM) étant configurée pour stocker une donnée et comprenant un transistor d'état (TE) ayant une grille flottante (FG) configurée pour stocker une charge représentative de ladite donnée et une grille de commande (CG), une structure capacitive (SC) comportant un premier corps électriquement conducteur (CC1) couplé à la grille flottante (FG), un deuxième corps électriquement conducteur (CC2) et un corps diélectrique (CD, IMD, LKBRDG) entre les deux corps électriquement conducteur (CC1, CC2), et des moyens de génération (CNTMSR) configurés pour générer un courant de fuite (ILK) entre le premier corps électriquement conducteur (CC1) et le deuxième corps électriquement conducteur (CC2) à travers le corps diélectrique (LKBRDG), le courant de fuite (ILK) étant apte à modifier la charge de la grille flottante (FG) et altérer ladite donnée.

## Description

Des modes de mise en oeuvre et de réalisation concernent la protection de données stockées dans une mémoire de circuit intégré, en particulier en réaction à des attaques invasives ou non-invasives.

La mémoire, en particulier une mémoire non-volatile, d'un circuit intégré peut être exposée à des attaques matérielles invasives ou non-invasives visant à récupérer les données qu'elle contient.

Les attaques matérielles dites « invasives » concernent les techniques d'ingénierie inversée permettant de reconstruire la structure physique du circuit intégré afin d'accéder au contenu de la mémoire. De telles techniques d'ingénierie inversée emploient par exemple une sonde ionique focalisée (connu par l'acronyme anglais « FIB » pour « Focused Ion Beam ») ou un laser.

Les attaques matérielles dites « non-invasives » concernent les techniques permettant de reconstituer le comportement interne du circuit intégré, notamment le code du micrologiciel interne (« firmware » en anglais) pour en déduire les données stockées dans la mémoire ou pour éventuellement en exploiter les vulnérabilités en vue de contourner les restrictions de licence et de logiciel. Les attaques non-invasives sont typiquement réalisées lorsque le circuit intégré est alimenté et en fonctionnement, et utilisent des techniques telles que l'injection de fautes ou l'attaque par canal auxiliaire par exemple.

Les données de la mémoire doivent être tenues secrètes par exemple si elles forment un élément essentiel pour l'analyse du fonctionnement du circuit intégré ou si elles contiennent une clé de chiffrement/déchiffrement, des informations d'identification ou d'authentification, ou pour toute autre raison.

Pour limiter le risque de fuite des informations tenues secrètes, il peut être envisagé de dissimuler les données, en utilisant une technique de brouillage de données par exemple (« data scrambling » en anglais) lors de leur stockage dans la mémoire.

Toutefois, la dissimulation des données n'est pas suffisante puisque les données peuvent devenir lisible lors de l'exécution de programmes, notamment des programmes du micrologiciel reconstitué suite à des attaques non-invasives.

En outre, il existe des moyens conventionnels pour détecter les attaques invasives ou non-invasives et permettre de déclencher en réaction une contremesure, comme par exemple une destruction du circuit intégré.

Il existe un besoin de fournir des techniques de contremesure à des attaques invasives ou non-invasives, afin notamment d'empêcher l'accès au contenu de la mémoire de manière extrêmement rapide et efficace, et sans dégrader le fonctionnement ni la structure du circuit intégré.

Selon un aspect, il est proposé un procédé d'altération d'au moins une donnée stockée dans au moins une cellule-mémoire d'un circuit intégré, ladite cellule-mémoire comprenant un transistor d'état ayant une grille flottante stockant une charge représentative de la donnée et une grille de commande.

Le procédé comprend un couplage à la grille flottante d'une structure capacitive comportant un premier corps électriquement conducteur couplé à la grille flottante, un deuxième corps électriquement conducteur et un corps diélectrique entre les deux corps électriquement conducteur, et une génération d'un courant de fuite entre le premier corps électriquement conducteur et le deuxième corps électriquement conducteur à travers le corps diélectrique, le courant de fuite modifiant la charge de la grille flottante et altérant ladite donnée.

En d'autres termes, les transistors d'états stockant les données sont connectés à des structures capacitives dont l'objectif est de modifier la charge stockée dans la grille flottante et d'altérer les informations de façon à les rendre inexploitables, par exemple en effaçant la mémoire.

La structure capacitive permet d'obtenir un effet capacitif entre d'un côté le premier corps électriquement conducteur qui est dans à potentiel flottant, d'un autre côté, le deuxième corps électriquement conducteur qui est commandable par un signal de tension, par exemple un signal haute tension.

Ainsi, les données stockées sont altérées ou perdues lors d'attaques matérielles invasives ou non-invasives dès lors que ces attaques ont été détectées, par exemple par des moyens de détection d'attaques invasives ou non-invasives. En particulier, la structure capacitive permet d'obtenir une altération sur les données de la mémoire, sans mettre en oeuvre une procédure conventionnelle d'écriture en mémoire (effacement/programmation) pouvant prendre plusieurs cycles d'horloge.

Selon un mode de mise en oeuvre, la génération du courant de fuite comprend une application d'une tension sur le deuxième corps supérieure à un seuil.

Le seuil est typiquement défini pour provoquer une modification des données contenues en mémoire lorsque la tension appliquée est supérieure à celui-ci et permet d'empêcher une modification des données lorsque cette tension est inférieure ou égale à celle-ci.

Un tel seuil permet d'éviter un courant de fuite non-désiré, généré par exemple par une tension parasite en l'absence de toute attaque non-invasive et invasive. On empêche ainsi une altération de la charge pouvant se manifester de façon inopportune.

Selon un mode de mise en oeuvre, on forme le corps diélectrique en interposant entre les deux corps un premier matériau diélectrique et en recouvrant les deux corps et le premier matériau diélectrique avec une couche de nitrure de silicium dont le silicium a un pourcentage en poids supérieur ou égal à 50%.

La couche de nitrure de silicium dit « Si-rich », c'est-à-dire dont le pourcentage en poids de silicium est supérieur ou égal à 50%, présente des caractéristiques avantageuses permettant de contrôler la génération du courant de fuite entre les deux corps électriquement conducteurs de façon à altérer la charge et d'isoler les corps conducteurs en l'absence d'attaques invasives ou non-invasives grâce aux propriétés isolantes de la couche de nitrure de silicium et premier matériau diélectrique. En outre, le courant de fuite généré par une telle couche de nitrure de silicium présente une allure en intensité plus avantageuse que celle d'un courant de fuite qui aurait été généré par une couche de nitrure de silicium non « Si-rich ».

La présence d'une couche de nitrure de silicium « Si-rich » permet d'obtenir un courant de fuite significatif, c'est-à-dire de l'ordre du centième de nanoampère, pour des gammes de tension typiques du circuit intégré, notamment des tensions de l'ordre de 8V par exemple, contrairement à une couche de nitrure de silicium classique produisant le même courant de fuite mais pour des tensions beaucoup trop élevées, de l'ordre de 45V par exemple. Le circuit intégré ne peut typiquement ni générer, ni supporter des tensions de cet ordre de grandeur.

Selon un mode de mise en oeuvre, ladite génération du courant de fuite est effectuée en réponse à une attaque invasive ou non invasive du circuit intégré.

Le deuxième corps électriquement conducteur des structures capacitives est parfaitement adapté pour être connecté électriquement à d'autres circuits, tels que des circuits de détection d'attaques matérielles invasives ou non-invasives capables de déclencher la génération du courant de fuite entre les corps électriquement conducteurs.

Selon un autre aspect, il est proposé un circuit intégré comprenant:
au moins une cellule-mémoire, ladite cellule-mémoire étant configurée pour stocker une donnée et comprenant un transistor d'état ayant une grille flottante configurée pour stocker une charge représentative de ladite donnée et une grille de commande, une structure capacitive comportant un premier corps électriquement conducteur couplé à la grille flottante, un deuxième corps électriquement conducteur et un corps diélectrique entre les deux corps électriquement conducteur, et des moyens de génération configurés pour générer un courant de fuite entre le premier corps électriquement conducteur et le deuxième corps électriquement conducteur à travers le corps diélectrique, le courant de fuite étant apte à modifier la charge de la grille flottante et altérer ladite donnée.

Selon un mode de réalisation, les moyens de génération comprennent un générateur de tension configuré pour appliquer une tension sur le deuxième corps supérieure à un seuil.

Selon un mode de réalisation, le corps diélectrique comprend un premier matériau diélectrique interposé entre les deux corps et une couche de nitrure de silicium dont le silicium a un pourcentage en poids supérieur ou égal à 50%, recouvrant les deux corps et le premier matériau diélectrique.

Selon un mode de réalisation, le premier corps électriquement conducteur comprend une première piste métallique s'étendant dans un niveau de métal, et le deuxième corps électriquement conducteur comprend une deuxième piste métallique longeant la première piste métallique dans le même niveau de métal.

Selon un mode de réalisation, le circuit intégré comprend plusieurs transistors d'état de plusieurs cellules-mémoire et plusieurs structures capacitives respectives, les structures capacitives étant situées dans des niveaux de métal différents d'une structure capacitive à une autre.

Selon un mode de réalisation, le circuit intégré comprend un circuit de détection apte à détecter une attaque invasive ou non invasive du circuit intégré et à activer les moyens de génération en réponse à une telle attaque.

Selon un mode de réalisation, la cellule-mémoire comprend en outre un transistor d'accès comportant une grille verticale enterrée dans un substrat semiconducteur, une région de source enterrée en profondeur dans le substrat et une région de drain commune à une région de source du transistor d'état.

Selon un mode de réalisation, le circuit intégré comporte en outre une mémoire non-volatile d'usage général, ladite cellule mémoire ayant la même structure et la même composition en matériaux que des cellules-mémoires de la mémoire non-volatile d'usage général.

Selon un autre aspect, il est également proposé un procédé de fabrication d'un circuit intégré comprenant :
une réalisation d'au moins une cellule-mémoire comprenant un transistor d'état ayant une grille flottante configurée pour stocker une charge représentative de ladite donnée et une grille de commande, une réalisation d'au moins une structure capacitive comportant une formation d'un premier corps électriquement conducteur couplé à la grille flottante, d'un deuxième corps électriquement conducteur et d'un corps diélectrique entre les deux corps électriquement conducteurs.

Le procédé comprend en outre une réalisation de moyens de génération configurés pour générer un courant de fuite entre le premier corps électriquement conducteur et le deuxième corps électriquement conducteur à travers le corps diélectrique, le courant de fuite étant apte à modifier la charge de la grille flottante et altérer ladite donnée.

Selon un mode de mise en oeuvre, la formation du corps diélectrique comprend une formation d'un premier matériau diélectrique interposé entre les deux corps et une formation d'une couche de nitrure de silicium dont le silicium a un pourcentage en poids supérieur ou égal à 50%, recouvrant les deux corps et le premier matériau diélectrique.

Selon un mode de mise en oeuvre, la formation du premier corps électriquement conducteur comprend une formation d'une première piste métallique s'étendant dans un niveau de métal, et la formation du deuxième corps électriquement conducteur comprend une formation d'une deuxième piste métallique longeant la première piste métallique dans le même niveau de métal.

Selon un mode de mise en oeuvre, le procédé comprend une formation de plusieurs transistors d'état de plusieurs cellules-mémoire et une formation de plusieurs structures capacitives respectives, les structures capacitives étant situées dans des niveaux de métal différents d'une structure capacitive à une autre.

Selon un mode de mise en oeuvre, la réalisation de la cellule-mémoire comprend une formation d'un transistor d'accès ayant une grille verticale enterrée dans un substrat semiconducteur de la cellule-mémoire, une région de source enterrée en profondeur dans le substrat et une région de drain commune à une région de source du transistor d'état.

Selon un mode de mise en oeuvre, le procédé comprend en outre une fabrication d'une mémoire non-volatile d'usage général, dans lequel ladite réalisation de ladite cellule-mémoire est mise en oeuvre par les mêmes étapes que des étapes de la fabrication de cellules-mémoires de la mémoire non-volatile d'usage général.

D'autres avantages et caractéristiques de l'invention apparaîtront à l'examen de la description détaillée de modes de réalisation et de mise en oeuvre, nullement limitatifs, et des dessins annexés, sur lesquels :
[Fig 1A] ;
[Fig 1B] ;
[Fig 2] ;
[Fig 3] ;
[Fig 4] ;
[Fig 5] ; et
[Fig 6] illustrent des modes de réalisation et de mise en oeuvre de l'invention.

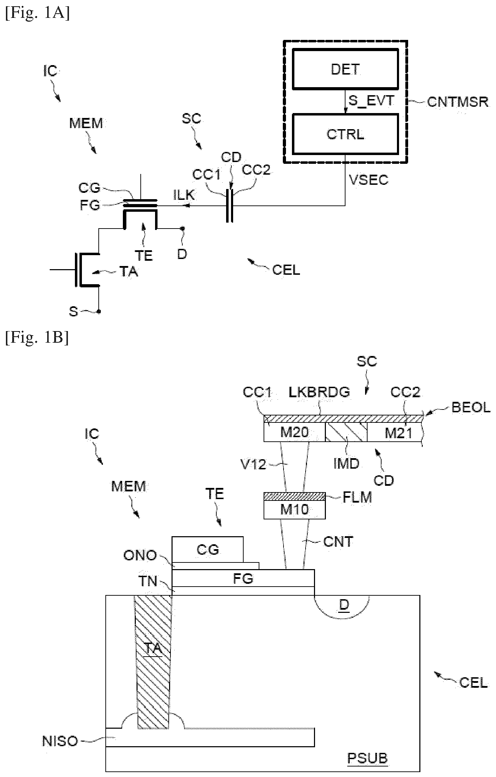

La figure 1A représente un schéma électrique d'une cellule mémoire MEM d'une mémoire d'un circuit intégré IC.
La figure 1B représente une vue en coupe de la même cellule mémoire MEM fabriquée dans et sur un substrat semiconducteur PSUB du circuit intégré IC.

La cellule mémoire MEM comporte un transistor d'accès TA, permettant de sélectionner la cellule mémoire MEM parmi d'autres dans la mémoire non volatile, selon un exemple de configuration de transistor enterrée à grille verticale.

La grille du transistor d'accès TA est formée par un matériau conducteur, par exemple du silicium polycristallin, remplissant une tranchée ouverte dans le substrat PSUB dont les parois ont été recouvertes d'un oxyde de grille. Une région semiconductrice enterrée NISO au niveau au fond de la tranchée forme une région de source S du transistor d'accès TA. Le transistor d'accès TA comporte une région de source NISO enterrée en profondeur dans le substrat PSUB et une région de drain commune, c'est-à-dire identique, à la région de source du transistor d'état TE.

La cellule mémoire MEM comporte un transistor d'état TE permettant de stocker une donnée. Le transistor d'état TE comporte une grille flottante FG et une grille de commande CG.

Pour écrire une donnée dans le transistor d'état TE, des charges sont injectées par effet Fowler-Nordheim à travers un diélectrique tunnel TN, entre la grille flottante FG et une région de drain D.

La grille de commande CG est électriquement isolée de la grille flottante FG par une région diélectrique du type oxyde-nitrure-oxyde de silicium ONO. La grille de commande CG permet de générer les champs électriques pour l'effet Fowler-Nordheim, et pour lire les données stockées. La lecture est basée sur une mesure de la tension de seuil sur la grille de commande CG du transistor d'état TE, qui est paramétrée par la charge de la grille flottante FG.

Ainsi la charge de la grille flottante FG dans chaque transistor d'état TE est représentative d'une donnée respective, « 0 » ou « 1 ».

Les données stockées dans les transistors d'états TE sont écrites afin d'être lues pour mettre en oeuvre une fonction du circuit intégré IC. Les transistors d'état TE peuvent stocker des données devant être tenues secrètes. Par exemple, des données qui doivent être tenues secrètes peuvent être les données qui codent des instructions de démarrage du circuit intégré, ou qui contiennent une clé de chiffrement/déchiffrement.

Le circuit intégré IC comporte en outre une structure capacitive SC comprenant un premier corps électriquement conducteur CC1 couplé à la grille flottante FG du transistor d'état TE, un corps diélectrique CD, et un deuxième corps électriquement conducteur CC2. Le corps diélectrique CD comprend un premier matériau diélectrique IMD interposé entre le premier corps CC1 et le deuxième corps CC2. Le premier matériau diélectrique IMD est configuré avec une faible constante diélectrique, généralement de structure poreuse, et par exemple en oxide de silicium.

Comme il est visible sur la figure 1B, la structure capacitive SC est formée à partir d'une première piste métallique M20 et d'une deuxième piste métallique M21 localisées dans un même niveau de métal de la partie d'interconnexion BEOL du circuit intégré (usuellement désignée par le terme anglais « Back End Of Line »).

La grille flottante FG du transistor d'état TE est couplée au premier corps électriquement conducteur CC1 par l'intermédiaire de contact CNT, reliant les éléments de la face avant du substrat PSUB avec une piste métallique M10 du premier niveau de métal, et par l'intermédiaire de vias V12 reliant la piste métallique M10 du premier niveau de métal à la première piste métallique M20 du deuxième niveau de métal. Bien que représenté à des fins de simplifications dans le deuxième niveau de métal, la structure capacitive SC peut avantageusement être formée dans des niveaux de métal plus élevés, sans limitation, par exemple le cinquième, le sixième ou le septième niveau de métal.

Le corps diélectrique CD comprend également une couche de nitrure de silicium (SiN) LKBRDG recouvrant les deux corps CC1 et CC2 et le premier matériau diélectrique IMD. La couche de nitrure de silicium LKBRDG possède avantageusement un pourcentage en poids de silicium supérieur ou égal à 50%.

En alternative, le corps diélectrique CD comprend une couche de carbonitrure de silicium (SiCN). La couche de carbonitrure de silicium LKBRDG possède avantageusement un pourcentage en poids de silicium supérieur ou égal à 40%. Par la suite, on fera uniquement référence à une couche de nitrure de silicium LKBRDG sans exclure l'usage de carbonitrure de silicium dont le pourcentage en poids de silicium et les caractéristiques électriques sont sensiblement les mêmes.

La couche de nitrure de silicium LKBRDG forme un film diélectrique dit « Si-rich » qui se distingue de film diélectrique classique en nitrure de silicium de stoechiométrie Si3N4 prévu habituellement entre un niveau de métal n et un niveau de métal n+1 pour protéger des pistes métalliques d'un même niveau. En effet, un film diélectrique « Si-rich » dont le pourcentage en poids de silicium est supérieur ou égal à 50% permet de générer un courant de fuite ILK entre le premier corps CC1 et le deuxième corps CC2 dont l'intensité est suffisamment élevée, par exemple 1 pA, pour permettre une altération de la charge dans la grille flottante FG lorsqu'une tension VSEC relativement faible, par exemple 7,5V, est appliquée sur le deuxième corps électriquement conducteur CC2. En outre, l'intensité du courant de fuite ILK dans un tel film diélectrique « Si-rich » croît plus vite en fonction de la tension VSEC sur le deuxième corps électriquement conducteur CC2, que celle du courant de fuite qui aurait été généré par un film diélectrique classique.

Le courant de fuite ILK généré par la couche de nitrure de silicium LKBRDG présentant cette proportion de silicium a une intensité supérieure ou égale à un centième de nanoampère (0,01 nA) lorsque la tension VSEC appliquée sur le deuxième corps électriquement conducteur CC2 atteint un seuil VLK égal à 7,5V. De façon analogue, un courant de fuite qui aurait été généré par la couche de carbonitrure de silicium « Si-rich », dont la proportion en silicium est légèrement inférieure à celle du nitrure de silicium « Si-rich », présenterait un même ordre de grandeur que le courant de fuite généré par la couche de nitrure de silicium pour une même valeur de tension VSEC.

Par exemple, un film diélectrique classique en nitrure de silicium Si3N4 génère un courant de fuite de même valeur d'intensité seulement pour des tensions supérieures à au moins 30V. Le circuit intégré IC ne peut typiquement ni générer, ni supporter des tensions de cet ordre de grandeur.

Le seuil VLK représente la tension nécessaire pour permettre une génération d'un courant de fuite ILK capable d'altérer les données de la cellule-mémoire MEM et peut varier selon le pourcentage en poids de silicium de la couche de nitrure de silicium LKBRDG. L'homme du métier saura adapter le pourcentage en poids de silicium pour obtenir la valeur de seuil VLK désirée.

Un courant de fuite ILK présentant une intensité supérieure ou égale à un centième de nanoampère (0,01 nA) permet de modifier la charge de la grille flottante FG afin d'altérer les données contenues dans la cellule-mémoire et de les rendre inexploitables sans endommager la cellule-mémoire MEM ni la structure capacitive SC. A titre d'exemple, on peut générer un courant de fuite ILK permettant d'effacer les données de la cellule-mémoire MEM.

La couche de nitrure de silicium LKBRDG tire ainsi bénéfice d'imperfections en termes d'isolation électrique rendant la couche LKBRDG plus permissive au passage du courant de fuite ILK pour des valeurs de tensions pouvant être générées par le circuit intégré IC sans risque d'endommagement, par exemple lors d'une attaque invasive ou non-invasive.

A cet égard, le circuit intégré IC comporte des moyens de génération CNTMSR comprenant un circuit de détection DET apte à détecter une attaque invasive ou non-invasive et un générateur de tension CTRL couplé électriquement au deuxième corps électriquement conducteur CC2.

Dans le cas d'une attaque non-invasive, le circuit de détection DET peut être par exemple un dispositif maître « de confiance » tel qu'un domaine sécurisé (usuellement « trusted domain » en anglais) d'un processeur, capable de détecter une intrusion illégale dans la mémoire ou une violation d'un système de protection de type « parefeu » et de prendre la décision de commander une contre-mesure.

Dans le cas d'une attaque invasive, le circuit de détection DET peut être un circuit connu de l'homme du métier, par exemple un circuit capable de détecter une variation d'une valeur résistive dans le substrat PSUB du circuit intégré IC résultant d'un amincissement du substrat PSUB.

Le générateur de tension CTRL est typiquement un régulateur de tension ou un convertisseur élévateur de tension (« step-up converter » en anglais), ou aussi une pompe de charge de conception classique capable de générer des tensions supérieures à 7,5V, par exemple une tension de 9V, à partir de l'alimentation du circuit intégré IC.

Les moyens de génération CNTMSR sont activés lorsqu'une attaque est détectée par le circuit de détection DET qui peut être configurée, selon un scénario possible, pour transmettre par exemple un signal de détection S_EVT au générateur de tension CTRL. Le générateur de tension CTRL est configuré pour générer, lors d'une réception du signal de détection S_EVT selon ce scénario, une tension VSEC sur le deuxième corps électriquement conducteur CC2 supérieure au seuil VLK, qui est pour rappel environ égal à 8V.

En l'absence de détection d'attaque invasive ou non-invasive, le générateur de tension CTRL génère une tension VSEC inférieure au seuil VLK afin d'éviter un courant de fuite non-désiré et une altération de la charge pouvant se manifester de façon inopportune.

Ainsi, les moyens de génération CNTMSR permettent de coopérer avec la structure capacitive SC de façon à mettre en oeuvre une contremesure visant à modifier, voir effacer les informations de la cellule-mémoire MEM en cas d'attaque invasive ou non-invasive.

Par exemple, le circuit intégré IC comporte une mémoire non-volatile d'usage général, c'est-à-dire pour stocker des données non-nécessairement critiques, les cellules mémoires de la mémoire d'usage général ne bénéficiant pas du mécanisme de contre-mesure obtenu par notamment la structure capacitive SC couplée à la grille flottante, tel que décrit précédemment.

La cellule mémoire MEM est avantageusement réalisée en cointégration avec la mémoire non-volatile d'usage général, c'est-à-dire réalisée par les mêmes étapes de fabrication, de sorte que la cellule mémoire MEM a la même structure et la même composition en matériaux que les cellules-mémoires de la mémoire non-volatile d'usage général.

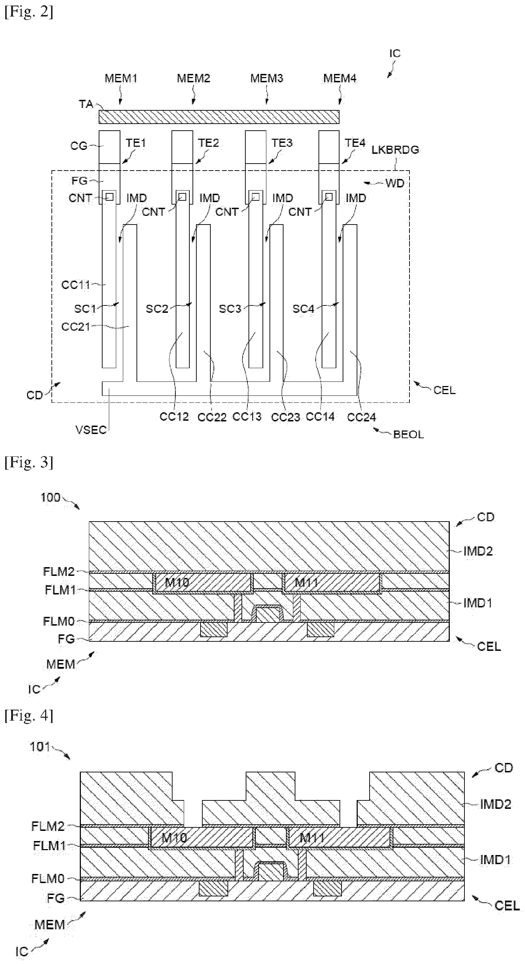

La figure 2 représente une vue du dessus du circuit intégré IC.

Le circuit intégré IC comprend classiquement plusieurs cellules mémoires MEM1, MEM2, MEM3, MEM4 telles que décrites en relation avec les figures 1A et 1B, par exemple regroupées par mot mémoire WD.

Ainsi les cellules mémoires MEM1-MEM4 comportent chacune un transistor d'état TE1-TE4, et partagent au sein d'un mot mémoire WD la structure du transistor d'accès TA.

Le circuit intégré IC comporte (au moins) une structure capacitive SC1-SC4 par transistor d'état TE1-TE4, chacune dans un niveau de métal. Ainsi, les structures capacitives SC1-SC4 peuvent être situées dans différents niveaux de métal, les niveaux de métal pouvant varier d'une structure capacitive à une autre.

Dans chaque structure capacitive SC1-SC4, le premier corps électriquement conducteur CC11-CC14 et le deuxième corps électriquement conducteur CC21-CC24 sont situées dans le même niveau de métal de la partie d'interconnexion BEOL du circuit intégré IC.

Le deuxième corps électriquement conducteur CC21-CC24 a une forme épousant au moins une partie du contour de la forme du premier corps électriquement conducteur CC11-CC14.

Dans l'exemple représenté, chaque premier corps électriquement conducteur CC11-CC14 est formé par une première piste métallique s'étendant dans une direction du plan du niveau de métal. Les deuxièmes corps électriquement conducteurs CC21-CC24 sont formés par des deuxièmes pistes métalliques longeant respectivement chaque première piste métallique dans le même niveau de métal.

Par ailleurs, les deuxièmes corps électriquement conducteurs CC21-CC24 peuvent être couplés au même générateur de tension CTRL décrit précédemment en relation avec la figure 1A de manière à ce que les données stockées par chaque transistor d'état TE du mot-mémoire WD soient modifiées ou supprimées simultanément en cas d'attaque.

Les figures 3 à 6 illustrent des étapes d'un procédé de fabrication du circuit intégré IC tel que décrit précédemment en relation avec les figures 1A et 1B.

La figure 3 illustre une étape 100 de formation d'une couche de matériau diélectrique IMD2 d'un niveau n+1 de métal de la partie d'interconnexion BEOL du circuit intégré IC.

A ce stade, le transistor d'état TE ainsi que les couches de matériaux d'un premier niveau n de métal sont déjà formées. La formation des couches du premier niveau n de métal comprend typiquement une gravure d'une première couche de matériau diélectrique IMD1 jusqu'à un premier film diélectrique FLM1, une formation de pistes métalliques M10 et M11 par un dépôt d'un métal, par exemple le cuivre (Cu), dans les espaces gravés de cette première couche de matériau diélectrique IMD1 suivi d'une formation d'un deuxième film diélectrique FLM2 recouvrant les pistes métalliques M10 et M11 et la première couche de matériau diélectrique IMD1.

Les premier et deuxième films diélectriques FLM1 et FLM2 sont des couches de nitrure de silicium classique de stoechiométrie Si3N4 par exemple.

Lors de l'étape 100, une deuxième couche de matériau diélectrique IMD2 est formée sur le deuxième film diélectrique FLM2. Les matériaux diélectriques IMD1 et IMD2 peuvent être les mêmes que le matériau diélectrique IMD décrit précédemment en relation avec les figures 1A à 2.

La figure 4 illustre une étape 101 de gravure de tranchées dédiées à la formation du premier corps conducteur CC1 et du deuxième corps conducteur CC2.

En particulier, les tranchées peuvent être formées en gravant la deuxième couche de matériau diélectrique IMD2 et le deuxième film diélectrique FLM2 de façon à découvrir au moins partiellement la surface des pistes métalliques M10 et M11.

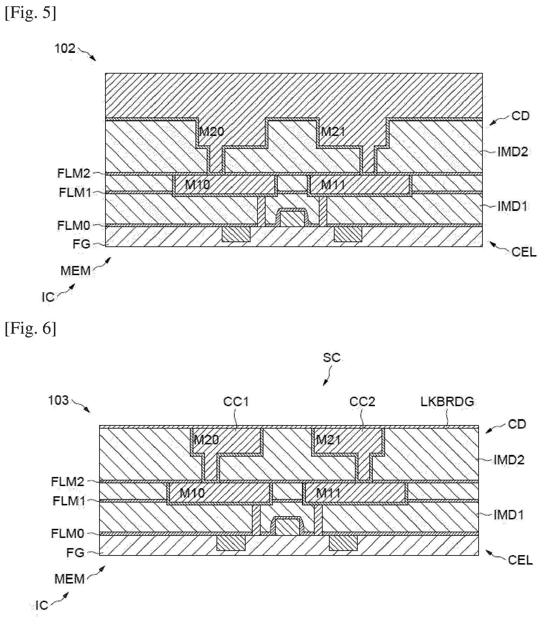

La figure 5 illustre une étape 102 de formation du premier corps électriquement conducteur CC1 et du deuxième corps électriquement conducteurs CC2. L'étape 102 peut notamment comprendre une formation d'une première piste métallique M20 et d'une deuxième piste métallique M21 par un dépôt d'un métal, par exemple le cuivre (Cu), dans les tranchées suivi d'un aplanissement mécano-chimique (désigné par l'acronyme « CMP » pour « chemical mechanical planarization » en anglais). Ainsi, le premier corps électriquement conducteur CC1 comprend la première piste métallique M20 s'étendant dans le niveau de métal n+1 et le deuxième corps électriquement conducteur CC2 comprend le deuxième piste métallique M21 du même niveau de métal n+1.

La figure 6 illustre une étape 103 de formation de la couche de nitrure de silicium LKBRDG. La couche de nitrure de silicium LKBRDG recouvre le premier corps électriquement conducteur CC1 et le deuxième corps électriquement conducteur CC2 ainsi que la deuxième couche de matériau diélectrique IMD2 de manière à former une structure capacitive SC. Le deuxième corps électriquement conducteur CC2 d'une telle structure capacitive SC, obtenue à la fin de l'étape 103, peut être couplé aux moyens de génération CNTMSR décrits précédemment en relation avec les figures 1A à 3. En particulier, le générateur de tension CTRL des moyens de génération CNTMSR est configuré pour générer une tension sur le deuxième corps électriquement conducteur CC2 de sorte que la couche de nitrure LKBRDG génère un courant de fuite ILK entre le premier corps CC1 et le deuxième corps CC2.

En effet, la couche de nitrure de silicium LKBRDG forme un film diélectrique dit « Si-rich » qui se distingue des films diélectriques FLM1 et FLM2 par sa proportion en silicium qui est supérieur ou égal à 50% et permet de générer un courant de fuite ILK entre le premier corps CC1 et le deuxième corps CC2 dont l'intensité est suffisamment élevée, par exemple 1 pA, pour permettre une altération de la charge dans la grille flottante FG lorsqu'une tension relativement faible, par exemple 7,5V, est appliquée sur le deuxième corps électriquement conducteur CC2. En outre, l'intensité du courant de fuite ILK dans un tel film diélectrique « Si-rich » croît plus vite en fonction de la tension VSEC sur le deuxième corps électriquement conducteur CC2, que celle du courant de fuite qui aurait été généré par un film diélectrique classique.

En alternative, l'étape 103 est une étape de formation d'une couche de carbonitrure de silicium (SiCN). La couche de carbonitrure de silicium LKBRDG est formée d'une façon analogue à celle de la couche de nitrure de silicium précédemment décrite et possède avantageusement un pourcentage en poids de silicium supérieur ou égal à 40%.

Le courant de fuite ILK généré par la couche de nitrure de silicium LKBRDG « Si-rich » a une intensité supérieure ou égale à un centième de nanoampère (0,01 nA) lorsque la tension appliquée sur le deuxième corps électriquement conducteur CC2 atteint un seuil VLK égal à 7,5V.

Le seuil VLK représente la tension nécessaire pour permettre une génération d'un courant de fuite ILK capable d'altérer les données de la cellule-mémoire MEM et peut varier selon le pourcentage en poids de silicium de la couche de nitrure de silicium LKBRDG. L'homme du métier saura adapter le pourcentage en poids de silicium pour obtenir la valeur de seuil VLK désirée.

## Revendications

1. Procédé d'altération d'au moins une donnée stockée dans au moins une cellule-mémoire (MEM) d'un circuit intégré (IC), ladite cellule-mémoire (MEM) comprenant un transistor d'état (TE) ayant une grille flottante (FG) stockant une charge représentative de la donnée et une grille de commande (CG), le procédé comprenant un couplage à la grille flottante (FG) d'une structure capacitive (SC) comportant un premier corps électriquement conducteur (CC1) couplé à la grille flottante, un deuxième corps électriquement conducteur (CC2) et un corps diélectrique (CD, IMD,LKBRDG) entre les deux corps électriquement conducteur (CC1, CC2), et une génération d'un courant de fuite (ILK) entre le premier corps électriquement conducteur (CC1) et le deuxième corps électriquement conducteur (CC2) à travers le corps diélectrique (LKBRDG), le courant de fuite (ILK) modifiant la charge de la grille flottante (FG) et altérant ladite donnée.

2. Procédé selon la revendication 1, dans lequel la génération du courant de fuite (ILK) comprend une application d'une tension (VSEC) sur le deuxième corps (CC2) supérieure à un seuil (VLK).

3. Procédé selon la revendication 2, dans lequel le seuil (VLK) est supérieur à la tension de programmation de la cellule-mémoire (MEM).

4. Procédé selon l'une des revendications 1 à 3, dans lequel on forme le corps diélectrique (CD, IMD, LKBRDG) en interposant entre les deux corps (CC1, CC2) un premier matériau diélectrique (IMD) et en recouvrant les deux corps (CC1, CC2) et le premier matériau diélectrique (IMD) avec une couche de nitrure de silicium (LKBRDG) dont le silicium a un pourcentage en poids supérieur ou égal à 50%

5. Procédé selon l'une des revendications précédentes, dans lequel ladite génération du courant de fuite (ILK) est effectuée en réponse à une attaque invasive ou non invasive du circuit intégré.

6. Circuit intégré comprenant :
au moins une cellule-mémoire (MEM), ladite cellule-mémoire (MEM) étant configurée pour stocker une donnée et comprenant un transistor d'état (TE) ayant une grille flottante (FG) configurée pour stocker une charge représentative de ladite donnée et une grille de commande (CG), une structure capacitive (SC) comportant un premier corps électriquement conducteur (CC1) couplé à la grille flottante (FG), un deuxième corps électriquement conducteur (CC2) et un corps diélectrique (CD, IMD, LKBRDG) entre les deux corps électriquement conducteur (CC1, CC2), et des moyens de génération (CNTMSR) configurés pour générer un courant de fuite (ILK) entre le premier corps électriquement conducteur (CC1) et le deuxième corps électriquement conducteur (CC2) à travers le corps diélectrique (LKBRDG), le courant de fuite (ILK) étant apte à modifier la charge de la grille flottante (FG) et altérer ladite donnée.

7. Circuit intégré selon la revendication 6, dans lequel les moyens de génération (CNTMSR) comprennent un générateur de tension (CTRL) configuré pour appliquer une tension (VSEC) sur le deuxième corps (CC2) supérieure à un seuil (VLK).

8. Circuit intégré selon la revendication 7, dans lequel le seuil (VLK) est supérieur à la tension de programmation de la cellule-mémoire (MEM).

9. Circuit intégré selon l'une des revendications 6 à 8, dans lequel le corps diélectrique (CD, IMD, LKBRDG) comprend un premier matériau diélectrique (IMD) interposé entre les deux corps (CC1, CC2) et une couche de nitrure de silicium (LKBRDG) dont le silicium a un pourcentage en poids supérieur ou égal à 50%, recouvrant les deux corps (CC1, CC2) et le premier matériau diélectrique (IMD).

10. Circuit intégré selon l'une des revendications 6 à 9, dans lequel, le premier corps électriquement conducteur (CC1) comprend une première piste métallique (M20) s'étendant dans un niveau de métal, et le deuxième corps électriquement conducteur (CC2) comprend une deuxième piste métallique (M21) longeant la première piste métallique (M1) dans le même niveau de métal.

11. Circuit intégré selon l'une des revendications 6 à 10, comprenant plusieurs transistors d'état (TE1-TE4) de plusieurs cellules-mémoire et plusieurs structures capacitives (SC1-SC4) respectives, les structures capacitives (SC1-SC4) étant situées dans des niveaux de métal différents d'une structure capacitive à une autre.

12. Circuit intégré selon l'une des revendications 6 à 11, comprenant un circuit de détection (DET) apte à détecter une attaque invasive ou non invasive du circuit intégré et à activer les moyens de génération (CNTMSR) en réponse à une telle attaque.

13. Circuit intégré selon l'une des revendications 6 à 12, dans lequel la cellule mémoire (MEM) comprend en outre un transistor d'accès (TA) comportant une grille verticale enterrée dans un substrat semiconducteur (PSUB), une région de source (NISO) enterrée en profondeur dans le substrat (PSUB) et une région de drain commune à une région de source du transistor d'état (TE).

14. Circuit intégré selon l'une des revendications 6 à 13, le circuit intégré comporte en outre une mémoire non-volatile d'usage général, ladite cellule mémoire (MEM) ayant la même structure et la même composition en matériaux que des cellules-mémoires de la mémoire non-volatile d'usage général.

15. Procédé de fabrication d'un circuit intégré comprenant : une réalisation d'au moins une cellule-mémoire (MEM) comprenant un transistor d'état (TE) ayant une grille flottante (FG) configurée pour stocker une charge représentative de ladite donnée et une grille de commande (CG), une réalisation d'au moins une structure capacitive (SC) comportant une formation d'un premier corps électriquement conducteur (CC1) couplé à la grille flottante (FG), d'un deuxième corps électriquement conducteur (CC2) et d'un corps diélectrique (IMD, LKBRDG) entre les deux corps électriquement conducteurs, et une réalisation de moyens de génération (CNTMSR) configurés pour générer un courant de fuite (ILK) entre le premier corps électriquement conducteur (CC1) et le deuxième corps électriquement conducteur (CC2) à travers le corps diélectrique (LKBRDG), le courant de fuite (ILK) étant apte à modifier la charge de la grille flottante (FG) et altérer ladite donnée.

16. Procédé selon la revendication 15, dans lequel la formation du corps diélectrique (IMD, LKBRDG) comprend une formation d'un premier matériau diélectrique interposé entre les deux corps et une formation d'une couche de nitrure de silicium (LKBRDG) dont le silicium a un pourcentage en poids supérieur ou égal à 50%, recouvrant les deux corps (CC1, CC2) et le premier matériau diélectrique (IMD).

17. Procédé selon l'une des revendications 15 ou 16, dans lequel la formation du premier corps électriquement conducteur (CC1) comprend une formation d'une première piste métallique (M20) s'étendant dans un niveau de métal, et la formation du deuxième corps électriquement conducteur (CC2) comprend une formation d'une deuxième piste métallique (M21) longeant la première piste métallique (M20) dans le même niveau de métal.

18. Procédé selon l'une des revendications 15 à 17, comprenant une formation de plusieurs transistors d'état (TE1-TE4) de plusieurs cellules-mémoire et une formation de plusieurs structures capacitives (SC1-SC4) respectives, les structures capacitives (SC1-SC4) étant situées dans des niveaux de métal différents d'une structure capacitive à une autre.

19. Procédé selon l'une des revendications 15 à 18, dans lequel la réalisation de la cellule-mémoire (MEM) comprend une formation d'un transistor d'accès (TA) comprenant une grille verticale enterrée dans un substrat semiconducteur (PSUB), une région de source (NISO) enterrée en profondeur dans le substrat (PSUB) et une région de drain commune à une région de source du transistor d'état (TE).

20. Procédé selon l'une des revendications 15 à 19, comprenant en outre une fabrication d'une mémoire non-volatile d'usage général, dans lequel ladite réalisation de ladite cellule-mémoire (MEM) est mise en oeuvre par les mêmes étapes que des étapes de la fabrication de cellules-mémoires de la mémoire non-volatile d'usage général.
